Europäisches Patentamt

European Patent Office

Office européen des brevets

(19)

(11) Publication number: **0 166 835**

**A2**

(12) # EUROPEAN PATENT APPLICATION

(21) Application number: **84402399.4**

(22) Date of filing: **26.11.84**

(51) Int. Cl.⁴: **H 05 K 7/10**

(30) Priority: **02.07.84 US 626733**

(43) Date of publication of application:
**08.01.86 Bulletin 86/2**

(84) Designated Contracting States:
**DE FR GB**

(71) Applicant: **AUGAT INC.**
**89 Forbes Boulevard**
**Mansfield Massachusetts 02048(US)**

(72) Inventor: **Damon, Neil F.**
**2400 S. Ocean Drive Ft. Pierce**
**Florida 33450(US)**

(72) Inventor: **Stokoe, Philip T.**
**42 Fieldstone Lane**
**No Attleboro Massachusetts 02760(US)**

(72) Inventor: **Bertoglio, Guido**
**Via Del Pino 7**
**CH-6962 Viganello(CH)**

(74) Representative: **Descourtieux, Philippe et al,**
**CABINET BEAU de LOMENIE 55 rue d'Amsterdam**
**F-75008 Paris(FR)**

(54) Uniform insertion and removal force bottom-loaded electrical socket.

(57) A bottom-loaded electrical socket 44 includes a housing having a plurality of socket contacts 46 individually slidably received loosely in corresponding ones of a plurality of socket contact receiving openings 48, and means integrally formed with the socket contacts and cooperative with the housing for providing uniform insertion and withdrawal forces as well as uniform lead wear characteristics whenever the leads extending from IC or other electronic packages are inserted and withdrawn from the socket. The socket contacts include an outer sleeve 49, and an inner sleeve 54 having at least two lead receiving fingers friction-fit 56 inside the outer sleeve. Each socket contact includes an alignment reference with respect to which the lead receiving fingers are selectively aligned relative to the outer sleeve, and with respect to which the socket contacts are selectively aligned in the housing. The socket contacts may advantageously be either soldered or wire-wrapped to printed circuit or other interconnection boards, and the socket may have a comparatively low profile. Means are disclosed for providing solder degassing.

Fig. 3

CROSS-REFERENCE TO RELATED APPLICATIONS

This invention is related to co-pending application Serial No. 6/499,280, entitled BOTTOM-LOADED ELECTRICAL CONNECTOR, filed on May 31, 1983 and assigned to the same assignee as the instant invention.

FIELD OF THE INVENTION

This invention is directed to the field of electronic interconnection devices, and more particularly, to a uniform insertion and removal force bottom-loaded electrical socket.

BACKGROUND OF THE INVENTION

The above-identified co-pending related application, incorporated herein by preference, discloses a novel bottom-loaded electrical connector that allows the selection of comparatively less expensive housing plastics materials than theretofore possible, prevents housing crack formation and propagation due to socket contact insertion stress, and eliminates bowing of the housing, among other things. Said connector includes a housing having a top and a bottom surface, and a plurality of socket contact receiving openings extending therethrough from the top to the bottom surface defining an intended interconnection pattern. A plurality of sockets contacts are individually slidably received loosely from the bottom in a corresponding one of the socket contact receiving openings. A plurality of thermally plastically deformable upstanding tabs integrally formed on the bottom surface individually proximate corresponding ones of the socket contact receiving openings are provided for retaining the socket contacts in their associated openings. The socket contacts each include a cylindrical outer sleeve having a depending cylindrical male portion either for insertion into a printed circuit or other interconnection board or for wire wrapping, and an inner sleeve friction-fit into the outer sleeve having a plurality of depending converging cantilevered fingers for individually receiving corresponding ones of the extending leads of an integrated circuit or other electronic package.

The orientation of the inner sleeve relative to the outer sleeve is random, and the orientation of the outer sleeve relative to the housing is random. Individual ones of the leads of the integrated circuit or other package thus mechanically abut dis-similar portions of corresponding ones of the depending converging cantilevered fingers in the associated socket contacts. The insertion and withdrawal of the integrated circuit or other electronic package leads into and out of the electrical connector therewith produces both uneven insertion and removel forces, as well as uneven wear of the individual extending leads of the integrated circuit or other electronic package, particularly where rectangular leads are provided.

SUMMARY OF THE INVENTION

The electrical socket of the present invention includes a bottom-loaded electrical socket of the type disclosed in the above-identified related application, and contemplates means coupled to each of the socket contacts and cooperative with the housing for providing both uniform insertion and withdrawal force and uniform lead wear characteristics. In one embodiment, the socket contacts each include a cylindrical outer sleeve having a depending electrode tail having a circular cross-section for insertion into a printed circuit or other interconnection board, and a portion intermediate the sleeve and depending electrode tail defining a planar surface for providing both a solder degassing path and an alignment reference.

In another embodiment, the socket contacts each include a cylindrical outer sleeve having a depending electrode tail having a square cross-section for wire-wrapping, and a portion intermediate the sleeve and the depending tail defining a surface cooperative with the socket contact retaining means for providing anti-rotation during wire-wrapping. In this embodiment, a selected face of the depending tail having a square cross-section defines an alignment reference.

In both embodiments, the inner sleeve portion is inserted into the outer sleeve portion such that the depending converging cantilevered fingers define a preselected orientation with respect to the alignment reference, and the socket contacts are slidably received loosely into the corresponding socket contact receiving openings with the alignment references defining a preselected orientation with respect to the housing of the socket. The extending leads of the integrated circuit or other electronic package thereby mechanically abut similar portions of the depending converging cantilevered fingers and therewith provide uniform withdrawal and insertion force as well as uniform lead wear characteristics. In addition, since alignment is defined, only two depending converging cantilevered fingers may therewith advantageously be implemented.

A laterally extending lip proximate the top surface provides an abutment in each of the socket contact receiving openings which prevent the unintended removal of the inner sleeve portion during integrated circuit lead removal, and prevents socket push-out during wire-wrapping. Bevelled surfaces on the top surface in a rectangular orientation proximate each of the socket contact receiving openings facilitate lead plugability. The socket contact retaining means in both embodiments preferably includes an annulus integrally formed on the bottom surface surrounding each of the socket contact receiving openings that are individiually thermally plastically deformable from an upstanding open position that allows the ready insertion of the socket contacts into their associated openings, and a closed position that provides an abutment which frictionally retains the selectively aligned socket contacts in the housing.

BRIEF DESCRIPTION OF THE DRAWINGS

These and other advantages and features of the present invention will become apparent as the invention becomes better understood by referring to the following exemplary and non-limiting detailed description of the preferred embodiments, and to the drawings, wherein:

Fig. 1 is an enlarged perspective view of a novel uniform insertion and removal force bottom-loaded electrical socket according to the present invention;

Fig. 2 is an enlarged, fragmentary, and broken-away bottom perspective view of the uniform insertion and removal force bottom-loaded electrical socket according to the present invention;

Fig. 3 is an enlarged, fragmentary, and partially broken-away sectional view of one embodiment of the uniform insertion and removal force bottom-loaded electrical socket according to the present invention;

Fig. 4 is an enlarged perspective view illustrating a socket contact of the uniform insertion and removal force bottom-loaded electrical socket of Fig. 3;

Fig. 5 is a plan and schematic view illustrating in Figures 5A-5D four embodiments of lead to contact finger interfaces of the uniform insertion and withdrawal force bottom loaded electrical socket according to the present invention;

Fig. 6 is an enlarged, fragmentary, and partially broken-away sectional view illustrating another embodiment of the uniform insertion and removal force bottom-loaded electrical socket according to the present invention; and

Fig. 7 is an enlarged perspective view of a socket contact of the uniform insertion and removal force bottom-loaded electrical socket of the Fig. 6 embodiment according to the present invention.

DETAILED DESCRIPTION OF THE INVENTION

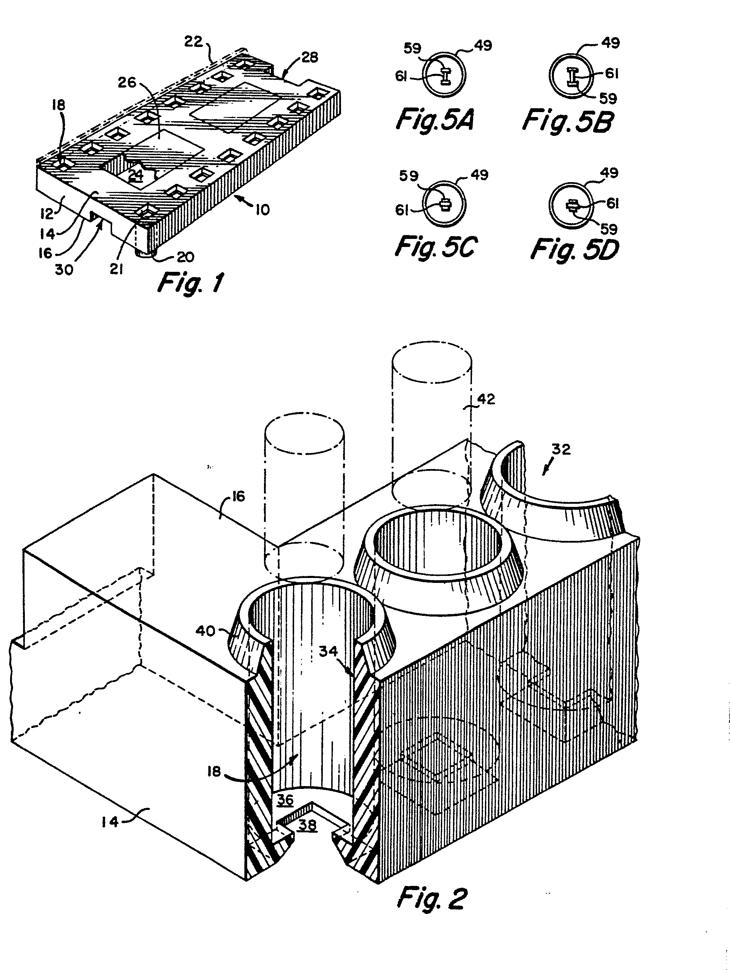

Referring now to Fig. 1, generally designated at 10 is an enlarged perspective view illustrating the novel uniform insertion and removal force bottom-loaded electrical socket according to the present invention. The socket 10 includes an insulative housing 12 having an upper surface 14 and a bottom surface 16. A plurality of socket contact receiving openings generally designated 18 to be described are provided through the insulative housing 12 that extend from the upper surface 14 to the bottom surface 16. The socket contact receiving openings 18 are preferably provided in rows laterally adjacent the sides of the socket 10 to define a so-called dual-in-line package (DIP) configuration, although any other suitable interconnection patterns can be provided as well.

A plurality of socket contacts 20, one being specifically illustrated, are individually slidably mounted loosely through the bottom surface 16 and into corresponding ones of the socket contact receiving openings 18. The socket contacts 20 are retained therein in a manner to be described. As disclosed in the above-identified co-pending related application, the loose-fit of the socket contacts in the associated socket contact receiving openings allows the selection of comparatively inexpensive housing plastics material, prevents strain-induced structural deformation of the housing, and among other advantages, eliminates bowing of the sides and ends of the housing which can be caused by sockets press fit into the body as conventionally done. The housing can be readily stacked in side-by-side and end-to-end relationship without milling the housings to standard dimensions. Any selected number of socket contacts, and socket contact receiving opening, can thereby expeditiously be provided.

A plurality of bevelled surfaces 21 are provided on the top surface 14 in a rectangular configuration surrounding corresponding ones of the openings 18 to facilitate lead plugability. A flange 22, shown dashed, may be provided laterally adjacent the sides of the housing 12 upon which laterally outermost ones of the bevelled surfaces 21 respectively surrounding corresponding ones of the openings 18 may be formed when desired to further facilitate lead plugability. One or more apertures generally designated 24, two being specifically illustrated, may be provided centrally of the housing 12 for conserving the usage of insulative plastics material. A thin sheet 26 may be formed integrally with the insulative housing 12 and flush with the top surface 14 to prevent dirt, dust and the like from accumulating in the one or more openings 24, and to allow vacuum loading with well-known automate socket contact loading devices. The sheet 26 may be formed integrally with the bottom surface as well. A notch generally designated 28 may be provided on an end of the insulative housing 12 for providing an indication of polarity. A channel generally designated 30 may be provided on the bottom surface 16 of the insulative housing that is cooperative with well-known automatic socket contact loading machines operative to orient the housing during socket contact loading.

Referring now to Fig. 2, generally designated at 32 is an enlarged, fragmentary, and broken-away perspective view of the bottom of the uniform insertion and removal force bottom-loaded electrical socket according to the present invention. Each of the socket contact receiving openings 18 include a cylindrical bore generally designated 34. The diameter of each of the bores 34 is selected to be slightly larger than the outside diameter of a socket contact slidably received therein to be described. A wall 36 having a rectangular lead receiving opening generally designated 38 is integrally formed with the top surface 14 of the socket 32 on one end of each of the socket contact receiving openings 18. The walls 36 prevent socket contact push-out both during wire-wrapping, which typically exerts a seven and one-half pound force thereagainst, and during IC lead removal, and eliminate the need for retaining barbs that heretofore resulted in undesirable housing distortion and cracking. An upstanding annulus 40 is integrally formed on the bottom surface 16 of the socket 32 surrounding the other end of each of the socket contact receiving openings 18. The annuli 40 are thermally plastically deformable inwardly to provide a circumferential sealing lip against which the socket contacts slidably inserted into corresponding ones of the socket contact receiving openings 18 are frictionally retained in their intended orientation preventing mis-alignment in use. As appears below, the annuli 40 also prevent anti-rotation during wire-wrapping. A plurality of upstanding standoffs 42, shown dashed, may be provided in spaced-apart relation integrally with the bottom surface 16 of the socket. The standoffs 42 serve both to provide an adaptor for use with conventional IC universal loading rails, and as appears more fully below, to provide solder degassing.

Referring now to Fig. 3, generally designated at 44 is an enlarged, fragmentary, and partially broken-away sectional view of one embodiment of a low-profile uniform insertion and removal force bottom-loaded electrical socket according to the present invention. A plurality of socket contacts generally designated 46 are individually slidably received loosely in correspond-

ing ones of a like plurality of socket contact receiving openings generally designated 48. The socket contacts 46 each include an outer cylindrical sleeve 49, a depending electrode tail 50 of circular cross-section integrally formed with the outer sleeve 49, an alignment surface 52 formed intermediate the tail 50 and outer sleeve 49, and an inner sleeve 54 having depending converging cantilevered lead engaging fingers 56 friction-fit inside the outer sleeve 49 as best seen in Fig. 4. The alignment surface 52 is preferably planar and tangent to a diameter of the tail 50. The inner sleeve 54 having the depending converging cantilevered fingers is friction-fit in the outer sleeve 49, with the fingers 56 at a preselected orientation with respect to the alignment surface 52. Each of the socket contacts 46 is slidably received in corresponding ones of the socket contact receiving openings 48, with the alignment surface 52 at a preselected orientation with respect to the socket 44. The annuli 40 are thermally plastically deformed to their closed position 58, shown dashed, for frictionally retaining the corresponding socket contact in its associated socket contact receiving opening with the cantilevered fingers 56 of the inner sleeve 54 in preselected alignment with respect to the housing.

The leads extending from integrated circuit or other electronic packages mechanically abut similar portions of the selectively aligned fingers 56 in each of the socket contacts 44, and therewith provide not only uniform insertion and withdrawal forces but also uniform wear characteristics of the leads. As seen in figure 4, two depending converging cantilevered lead receiving fingers 59, selectively aligned with respect to the socket contact, as well as other fingers such as those disclosed and claimed in U.S. Patents 4,186,990 and 4,296,549,both incorporated herein by reference and assigned to the same assignee as the instant invention, may advantageously be used. As shown in Figures 5A-5D, the cantilevered lead receiving fingers 59 can have either arcuate or flat IC lead engaging surfaces, and when rectangular IC leads 61 are engaged, the lead engaging surfaces of the lead receiving fingers 59 can engage either the sides or the ends of the rectangular leads 61, although it is presently preferred to have flat surfaces engage the sides of rectangular leads as shown in Figure 5C and to have arcuate surfaces engage the ends of rectangular leads as shown in Figure 5B. It will readily be appreciated that the use of two selectively aligned fingers minimizes material usage with attendant cost savings.

The alignment surfaces 52 provide solder degassing passageways. When the socket 44 is mounted to a printed circuit or other interconnection board 60, shown dashed, each of the depending electrode tails 50 of the socket contacts 46 are received in circular apertures, generally designated 62, provided therefor through the printed circuit board 60. Typically, the depending electrode tails 50 are then wave-soldered to the printed circuit board 60, and any gas thereby generated escapes through the passages defined between the surfaces of the alignment reference 52 and the diameter of the corresponding lead receiving aperture 62 in the printed circuit board. It should be noted that the socket 44 has a comparatively low-profile, and that the position of the fingers 59 is comparatively close to the top  surface of the housing which further facilitate lead plugability.

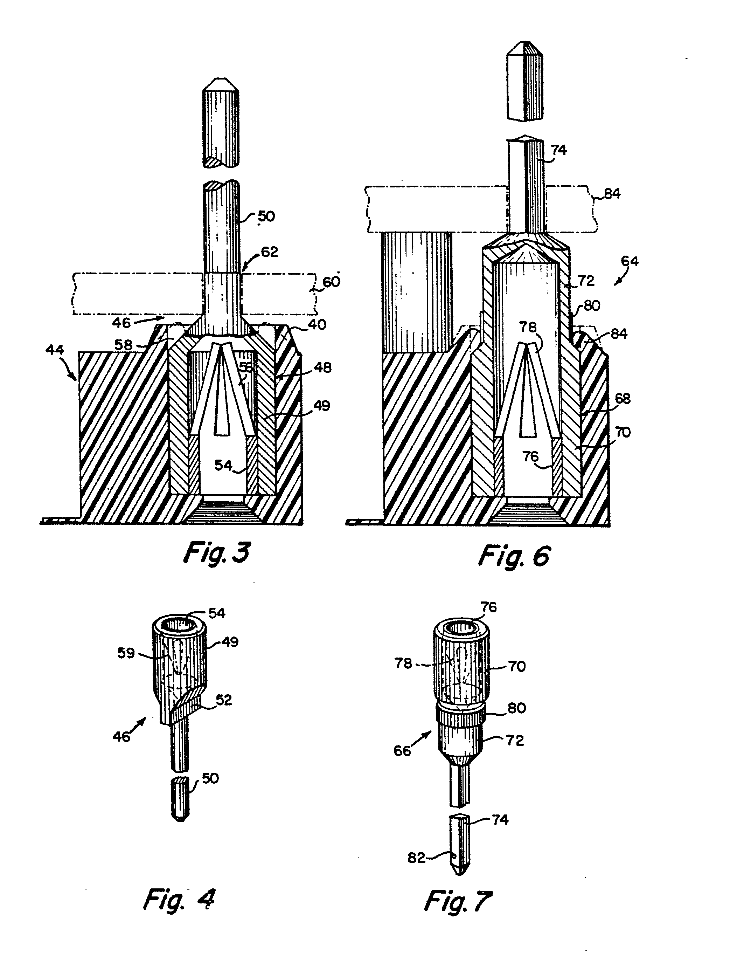

Referring now to Fig. 6, generally designated at 64 is an enlarged, fragmentary, and partially broken-away sectional view illustrating another embodiment of the uniform insertion and removal force bottom-loaded electrical socket according to the present invention suitable for wire-wrapping. A plurality of socket contacts generally designated 66 are individually slidably received loosely in corresponding ones of the like plurality of socket contact receiving openings generally designated 68. The socket contacts 66 each include an outer cylindrical sleeve portion 70, a subjacent smaller cylindrical portion 72 having an integral depending electrode tail 74 having a square cross-section, and an inner sleeve 76 having depending converging cantilevered fingers 78 friction-fit inside the outer sleeve 70 as best seen in Fig. 7. Two or more depending converging cantilevered fingers can advantageously be employed as described above in connection with the description of Fingers 3, 4, 5. An irregular surface 80, preferably straight knurled, is circumferentilly provided around the portion 72. A selected face, for example as designated 82, of the electrode tail 74 of each of the socket contacts 66 provides an alignment reference.

The inner sleeve 76 having the depending converging cantilevered lead receiving fingers 78 is friction-fit in the outer sleeve 70, with the cantilevered fingers 78 selectively oriented with respect to the alignment reference 82. The socket contacts 66 are slidably received loosely in corresponding ones of the socket contact receiving openings 68, with the alignment reference 82 at a preselected orientation with respect to the socket 64. The annuli 40 are thermally plastically deformed to their closed condition 84, with the cantilevered fingers 78 of the inner sleeve 76 in preselected alignment with respect to the housing, and frictionally engage the knurled surface 80 of corresponding ones of the socket contacts 66.

When the socket 64 is mounted to a printed circuit or other interconnection board 84, and the depending electrode tails 74 are wire-wrapped, the preselected alignment of the socket contacts 66 is maintained against rotation due to the frictional engagement of the annuli 40 and knurled surfaces 80. The leads extending from integrated circuit or other electronic packages thereby mechanically abut similar portions of the cantilevered fingers 78 of the inner sleeve 76 both providing uniform insertion and removal force and uniform wear characteritsics of the individual leads. It will be appreciated that the electrode tail portions 72 may have a circular cross-section, and may also be soldered to the printed circuit or other interconnection board 84. In the latter case, the standoffs 40 provide solder degassing. It shall be noted that the fingers 78 are close to the top surface of the housing and facilitate lead plugability.

It will be appreciated that many modifications of the presently disclosed invention will become apparent to those skilled in the art without departing from the scope of the appended claims.

0166835

## CLAIMS

1.    An electrical socket for receiving an integrated circuit or other electronic device having leads, comprising:

a housing having an upper and a lower surface, and a plurality of socket contact receiving openings therethrough extending between the upper and lower surface, each of said openings having a first preselected cross-sectional dimension;

a like plurality of lead receiving socket contacts each of a second preselected cross-sectional dimension less than the first preselected dimension and individually slidably mounted loosely in corresponding ones of said openings;

means coupled to said housing for retaining the socket contacts in their associated socket contact receiving openings; and

means coupled to each of said socket contacts and cooperative with said housing for providing uniform lead insertion and lead withdrawal forces.

2.    The invention of claim 1, wherein said lead receiving socket contacts are slidably inserted through the bottom surface of the housing; wherein each of said lead receiving socket contacts includes an outer sleeve having a depending electrode tail, an inner sleeve having a plurality of converging cantilevered lead receiving fingers friction-fit inside said outer sleeve; and wherein said uniform lead insertion and lead withdrawal forces providing means includes a surface integrally formed with each of said socket contacts with respect to which said plurality of depending converging cantilevered fingers are selectively oriented, and with respect to which each of said socket contacts are selectively oriented with respect to said housing.

3.     The invention of claim 2, wherein said outer sleeve of each of said socket contacts is cylindrically shaped, and wherein said surface thereof is integrally formed with each of said socket contacts intermediate said outer cylindrical sleeve and said depending electrode tail.

4.     The invention of claim 3, wherein two depending converging fingers are integrally provided with said inner sleeve.

5.     The invention of claim 3, wherein said electrode tail of each of said socket contacts has a circular cross-section, and wherein said surface is planar.

6.     The invention of claim 3, wherein said socket contact retaining means includes a thermally plastically deformable upstanding annulus integrally formed with the bottom surface of the housing proximate corresponding ones of the socket contact receiving openings.

7.     The invention of claim 2, wherein said electrode tail of each of said socket contacts has a rectangular cross-section, wherein said surface is a selected face of each of said electrode tails, and wherein said socket contact retaining means includes an irregular surface intermediate the outer sleeve and depending tail of each of said socket contacts.

8.     The invention of claim 7, wherein said socket contact retaining means further includes a plurality of thermally plastically deformable upstanding annuli integrally formed with the bottom surface of the housing proximate corresponding ones of the socket contact receiving openings that are cooperative with corresponding ones of said irregular surfaces of said socket contacts to retain said socket contacts in said openings and to provide anti-rotation during wire-wrapping of said tails having a square cross-section.

9. The invention of claim 7, further including a plurality of upstanding stand-offs integrally formed in spaced-apart relation on the bottom surface of the housing.

10. A socket for receiving an integrated circuit or other electronic component having leads, comprising :

a housing having socket contact receiving openings therethrough that are in communication with the top of the housing via a thin socket contact pushout preventing wall and in open communication with the bottom of the housing;

socket contacts having wire-wrap tails and intermediate knurled portions each slidably received loosely from the bottom into a corresponding socket contact receiving opening ; and

means integrally formed with the housing and cooperative with the knurled portions of the socket contacts for frictionally retaining the socket contacts in the socket contact receiving openings.

11. The invention of claim 10, wherein the retaining means are annuli integrally formed with the bottom of the housing and surrounding the socket contact receiving openings that are thermally plastically deformable from an open position that permits socket contact insertion and a closed position that frictionally abuts the knurled portions.

12. The invention of claim 11, wherein each socket contact includes fingers selectively aligned with respect to the socket contact, and wherein the socket contacts are selectively aligned with respect to the housing to provide uniform insertion and withdrawal force.

Fig. 1

Fig.5A

Fig.5B

Fig.5C

Fig.5D

Fig. 2

Fig. 3

Fig. 6

Fig. 4

Fig. 7